# EUROPÄISCHE PATENTANMELDUNG

(11) **EP 2 541 610 A1**
(43) Veröffentlichungstag der Anmeldung: **02.01.2013**
(21) Anmeldenummer: 11171439.0
(22) Anmeldetag: 27.06.2011
(51) Int. Cl.: H01L 31/02, H01L 31/042, H01L 31/048

(54) **Photovoltaik-Modul**

(71) Anmelder: KIOTO Photovoltaics GmbH, 9300 St. Veit (AT)
(72) Erfinder: Spielberger, Markus, AT-9334 Guttaring (AT); Waldi, Christian, AT-9061 Emmersdorf (AT); Eusch, Ingram, AT-9500 Villach (AT); Zechner, Martin, AT-9073 Viktring (AT)
(74) Vertreter: Becker, Thomas

(57) **Zusammenfassung**

Die Erfindung betrifft einen Photovoltaik-Modul mit einem Abdeckglas unterschiedlicher Lichtdurchlässigkeit.

## Beschreibung

Die Erfindung betrifft einen Photovoltaik-Modul. Hauptbestandteile eines solchen Solar-Moduls sind:
- Solarzellen (Photovoltaik-Zellen), meist aus kristallinem Silizium
- eine transparente Abdeckung, oft aus Glas
- Folien, in oder zwischen die die Solarzellen mit ihrer zugehörigen elektrischen Kontaktierung (Leiterbahnen) und elektrischen Anschlusselementen eingebettet sind
- eine der transparenten Abdeckungen gegenüberliegende Schutzschicht, auch "backsheet" genannt.

Es ist bekannt, die transparente Abdeckung (Schicht), die Folien (Klebeschichten) mit dazwischen liegenden Photovoltaik-Zellen sowie die Schutzschicht übereinander anzuordnen und in einem Vakuum-Laminierverfahren zu einer kompakten, lunkerfreien Einheit, dem Photovoltaik-Modul, zu verbinden. Durch die Erwärmung während des Laminiervorgangs (beispielsweise 200°C) werden die genannten Folien viskos, füllen Hohlräume zwischen und um die Photovoltaik-Zellen sowie Leiterbahnen und elektrischen Anschlusselemente aus und bilden gleichzeitig die gewünschte Klebeverbindung zwischen der transparenten Abdeckung und der Photovoltaik-Ebene beziehungsweise der Photovoltaik-Ebene und der Schutzschicht.

Der so hergestellte Photovoltaik-Modul wird üblicherweise anschließend in einem Rahmen konfektioniert. Die Grundform des Moduls ist prinzipiell beliebig. Ganz überwiegend weist der Modul jedoch eine rechteckige beziehungsweise quaderförmige Grundform auf.

Photovoltaik-Module der genannten Art werden seit Jahren in großem Umfang privat und gewerblich eingesetzt.

Während die Geometrie der Photovoltaik-Zellen sowie die Anordnung der daraus gebildeten "strings" (als "string" bezeichnet man mehrere, untereinander über Leiterbahnen verbundene Photovoltaik-Zellen) normalerweise sehr präzise ausgeführt sind, stellt es herstellungstechnisch ein Problem dar, die meist als Flachleiter ausgebildeten elektrischen Anschlusselemente zur Verbindung der Gruppen (strings) von Photovoltaik-Zellen präzise und optisch ansprechend zu verlegen. In der Regel geschieht dies manuell, wobei die Flachleiter typischerweise parallel zu korrespondierenden Randabschnitten des Moduls verlaufen, also überwiegend außerhalb der Fläche, die von den Photovoltaik-Zellen belegt ist.

Um die häufig unregelmäßig (schief, wellenförmig) verlegten elektrischen Anschlusselemente (Flachleiter) "zu kaschieren" ist es bekannt, einen Abdeckstreifen, im englischen "cover strip" genannt, als eigenständiges Bauteil im Modul zu verlegen, und zwar zwischen der lichttransparenten Schicht (Abdeckung) und die von den Photovoltaik-Zellen definierte Ebene.

Diese Abdeckstreifen werden häufig lose eingelegt oder zusammen mit den Photovoltaik-Zellen einlaminiert.

Abgesehen von diesem zusätzlichen Arbeitsschritt stellt sich auch die exakte Verlegung eines separaten Abdeckstreifens als Problem dar, so dass die Optik des fertigen Photovoltaik-Moduls häufig unbefriedigend ist.

Aufgabe der Erfindung ist es, dieses Problem zu lösen.

Grundgedanke der Erfindung ist es, auf einen separaten Abdeckstreifen zu verzichten, jedoch Maßnahmen vorzusehen, die elektrischen Anschlusselemente optisch so zu kaschieren, dass sie vom Betrachter überwiegend nicht wahrgenommen werden. Dabei geht die Erfindung von der Überlegung aus, die Abschnitte der lichttransparenten Schicht, die die genannten elektrischen Anschlusselemente überdecken, zumindest teilweise so auszubilden, dass sie eine deutlich reduzierte Lichtdurchlässigkeit gegenüber den Bereichen aufweist, die die Photovoltaik-Zellen überdecken.

Mit anderen Worten: Im Bereich der Photovoltaik-Zellen kommt es selbstverständlich darauf an, möglichst viel Licht durchzulassen, um den Wirkungsgrad der Zellen zu optimieren. Im Überdeckungsbereich zu den elektrischen Anschlusselementen geht es demgegenüber darum, diese soweit abzudecken, dass beispielsweise eine fehlerhafte (zum Beispiel wellenförmige) Verlegung vom Betrachter optisch nicht (mehr) wahrgenommen wird.

Der Vorteil gegenüber einer Abdeckung mittels separater Abdeckstreifen besteht darin, dass die entsprechenden Zonen (Bereiche, Abschnitte) der lichttransparenten Schicht vor der Konfektionierung des Photovoltaik-Moduls exakt definiert und vorbereitet werden können, und zwar in situ. Das bedeutet, dass die lichttransparente Schicht, üblicherweise ein Glas, entsprechende Bereiche/Zonen erhält, die eine geringere Lichtdurchlässigkeit aufweisen, wobei diese Zonen in präziser Form und Größe extern ausgebildet werden können. Ein separater Schritt beim Zusammenbau des Photovoltaik-Moduls entfällt.

Die Erfindung betrifft danach in ihrer allgemeinsten Ausführungsform einen Photovoltaik-Modul mit mehreren Photovoltaik-Zellen, die nebeneinander entlang einer Ebene angeordnet und von einer lichttransparenten Schicht abgedeckt sind, wobei Leiterbahnen benachbarte Photovoltaik-Zellen elektrisch miteinander verbinden und Gruppen von Photovoltaik-Zellen über elektrische Anschlusselemente verbunden sind, dadurch gekennzeichnet, dass die lichttransparente Schicht im Überdeckungsbereich der elektrischen Anschlusselemente zumindest einen Bereich aufweist, der eine um mindestens die Hälfte reduzierte Lichtdurchlässigkeit gegenüber den die Photovoltaik-Zellen überdeckenden Bereichen hat.

Die Angabe der "Lichtdurchlässigkeit" bezieht sich auf den Wellenlängenbereich des sichtbaren Lichts von 380 nm bis 780 nm gemäß DIN EN 410.

Wie ausgeführt soll die lichttransparente Schicht in dem Bereich, der die Photovoltaik-Zellen überdeckt, eine möglichst hohe Lichtdurchlässigkeit aufweisen, die deshalb nach verschiedenen Ausführungen mindestens 80%, vorzugsweise mindestens 90% beträgt. Glas, beispielsweise Einscheibensicherheitsglas (ESG) weist üblicherweise eine Lichtdurchlässigkeit von über 90% auf.

Der Bereich, der die elektrischen Anschlusselemente abdecken soll, also der Bereich der lichttransparenten Schicht mit reduzierter Lichtdurchlässigkeit, weist nach Ausführungsformen der Erfindung eine Lichtdurchlässigkeit von weniger als 40%, beispielsweise weniger als 30% auf. Dieser Wert kann bis auf null sinken.

Die reduzierte Lichtdurchlässigkeit kann auf unterschiedliche Art und Weise ausgebildet werden, in jedem Fall ist der entsprechende Bereich jedoch integraler Bestandteil der lichttransparenten Schicht. Dies kann erreicht werden beispielsweise durch:
- Eine Siebdruck-Beschichtung
- eine aufgeraute Oberfläche
- eine geätzte Oberfläche
- eine Glasfärbung
in entsprechenden Abschnitten der glastransparenten Schicht.

Herstellungstechnisch weist die Siebdrucktechnologie wesentliche Vorteile auf. Sie kann beim Vorspannen eines Glases dauerhaft eingebrannt werden. Die Siebdruck-Strukturen (Konturen) sind faktisch beliebig. Es können kleinste Bereiche, Linien, Flächen beliebiger Geometrie im Siebdruck ausgebildet werden. Dabei können auch aneinander angrenzende Bereiche mit unterschiedlicher Lichtdurchlässigkeit ausgebildet werden. Die Siebdrucktechnik ermöglicht es, die entsprechenden Bereiche mit beliebigen Farben zu versehen, die Bereiche satiniert oder matt zu gestalten. Ein Siebdruck ist kratz- und abriebfest sowie dauerhaft beständig.

Die elektrischen Anschlusselemente verlaufen von einer Photovoltaik-Zelle (beziehungsweise dem zugehörigen String) üblicherweise zunächst erst ein Teilstück in Richtung auf den Rand des Photovoltaik-Moduls und anschließend parallel zu diesem Rand. Insoweit sieht eine Ausführungsform der Erfindung vor, den Bereich der lichttransparenten Schicht mit reduzierter Lichtdurchlässigkeit streifenförmig zu gestalten, wobei die entsprechenden Streifen auf unterschiedliche Weise gebildet sein können, beispielsweise:
- Es können mehrere dünne Streifen parallel und in geringem Abstand zueinander abgebildet werden,
- es kann ein einziger, breiter Streifen gewählt werden,
- der Streifen kann eine Rechteckform, aber auch jede andere innere und äußere geometrische Form aufweisen, beispielsweise rautenartig oder der Geometrie der Photovoltaik-Zellen angepasst.

Die generelle Ausrichtung des Bereiches mit reduzierter Lichtdurchlässigkeit ist jedoch parallel zum Rand des Photovoltaik-Moduls, beispielsweise an zwei gegenüberliegenden, parallel zueinander verlaufenden Rändern des Moduls, aber auch umlaufend und damit quasi parallel zu einem etwaigen Rahmen des Moduls.

Dadurch, dass der Bereich mit reduzierter Lichtdurchlässigkeit dahinter (aus Sicht des Betrachters) verlaufende Bauteile partiell oder vollständig abdeckt, ist es auch möglich, diesen Bereich zu nutzen, um einen elektronischen Baustein (= Sensor, englisch: tag, chip) anzuordnen, mit dem eine Identifizierung des Photovoltaik-Moduls möglich wird, ohne dass dieser Sensor den optischen Gesamteindruck des Moduls stört.

Ein solcher Sensor kann beispielsweise ein RFID-Chip sein, (RFID = "radio-frequency-identification"), auf dem sich Daten zur Identifizierung des jeweiligen Photovoltaik-Moduls speichern und (später) auslesen/abrufen lassen. Hierzu gehören beispielsweise Informationen über den Hersteller, das Herstellungsdatum, die verwendeten Materialien, die Leistung der einzelnen Photovoltaik-Zellen, die Gesamtleistung der Moduls etc..

Dieser Sensor wird nach einer Ausführungsform so positioniert, dass er keine der Photovoltaik-Zellen (auch Solarzellen genannt) und keine der Leiterbahnen oder elektrischen Anschlusselemente überdeckt, Mit anderen Worten: Der Sensor wird in einem Bereich angeordnet, der frei von elektrisch leitenden Teilen ist. Eine zweckmäßige Position für das elektronische Bauteil lässt sich wie folgt definieren: zwischen dem n-ten und (n+1)-ten string, wobei n eine gerade Zahl ist und/oder zwischen Endabschnitten benachbarter elektrischer Anschlusselemente (gemäß vorstehender Definition), das heißt: in dem (Rand)Bereich, der frei von Solarzellen ist. Dazu kann der Sensor zwischen der lichttransparenten Schicht und der Ebene der Photovoltaik-Zellen platziert werden. Eine andere Möglichkeit ist es, den Sensor in der Ebene der Photovoltaik-Zellen anzuordnen, beispielsweise unmittelbar mit den Photovoltaik-Zellen, Leiterbahnen und elektrischen Anschlusselementen einzulaminieren.

Wie ausgeführt erfolgt dies vorzugsweise so, dass der Sensor zumindest teilweise von dem Bereich der lichttransparenten Schicht mit reduzierter Lichtdurchlässigkeit überdeckt wird.

Beispielsweise zur Identifizierung der Position des Sensors kann es gewünscht sein, im Überdeckungsfeld mindestens eine optische Markierung vorzusehen. Dies kann beispielsweise dadurch erfolgen, dass bei der Herstellung des Bereiches mit reduzierter Lichtdurchlässigkeit im Siebdruckverfahren eine Kodierung ausgebildet wird, die von außen sichtbar ist und die Position des Sensors anzeigt. Dies kann auf optisch unauffällige beziehungsweise optisch ansprechende Weise erfolgen, im einfachsten Fall dadurch, dass die entsprechende Kodierung Zonen definiert, die eine unterschiedliche Lichtdurchlässigkeit und/oder Farbe gegenüber dem benachbarten Abschnitten aufweisen.

Weitere Merkmale der Erfindung ergeben sich aus den Merkmalen der Unteransprüche sowie den sonstigen Anmeldungsunterlagen.

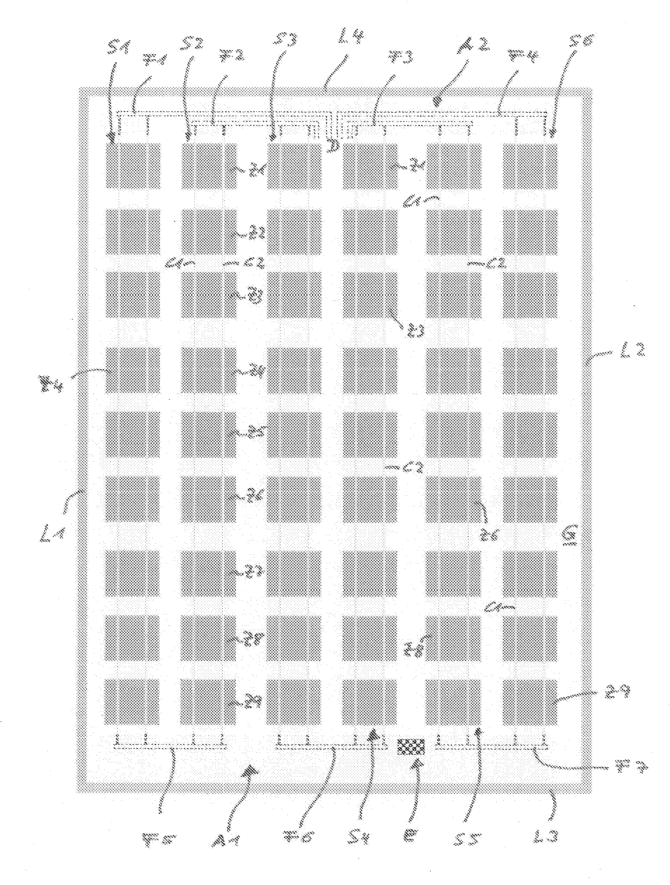

Die Erfindung wird nachstehend anhand eines Ausführungsbeispieles näher erläutert, Dabei zeigt die einzige Figur - in schematisierter Darstellung - eine Aufsicht auf einen erfindungsgemäßen Photovoltaik-Modul.

Der dargestellte Photovoltaik-Modul besteht aus sechs so genannten strings S1....S6, die parallel zu Längsrändern L1, L2 und mit Abstand zueinander verlaufen. Jeder string S1...S6 besteht aus neun Siliziumzellen Z1...Z9, wie beispielhaft für den string S2 markiert, Die Zellen Z1...Z9 verlaufen ebenfalls im Abstand zueinander. Benachbarte Zellen Z1, Z2; Z3, Z4... Z8, Z9 sind auf bekannte Art und Weise über elektrische Leiterbahnen C1, C2 verbunden.

Wie dargestellt sind die Leiterbahnen C1, C2, die zu beziehungsweise von den innerhalb eines strings S1...S6 äußeren Zellen Z1, Z9 verlaufen, mit elektrischen Anschlusselementen (Flachleitern F1...F7) verbunden, und zwar wie folgt: die strings S1, S2 sind über einen Flachleiter F5 benachbart zu einem unteren Rahmenabschnitt L3 des Moduls verbunden, während der Flachleiter F1 in Verlängerung der Leiterbahnen C1, C2 im Bereich eines oberen Rahmenendes L4 vom string S1 zu einer (nicht dargestellten) Anschlussdose D verläuft. Von dieser Anschlussdose D verläuft der Flachleiter F2 zu den strings S2, S3 und ist dort an die entsprechenden Leiterbahnen C1, C2 angeschlossen.

Die anderen elektrischen Verbindungen zwischen den strings S1....S6 beziehungsweise den Zellen Z1....Z9 und der elektrischen Anschlussdose D ergeben sich aus der Figur. Sie werden hier nicht näher dargestellt, da diese Anordnung zum Stand der Technik gehört.

Der Bereich benachbart dem oberen und unteren Rahmenende L4, L3 ist wie folgt gestaltet:

Bereiche benachbart des unteren und oberen Rahmenendes L3, L4 einer lichttransparenten Schicht G, die die Zellen Z1....Z9 beziehungsweise strings S1....S6, zugehörigen Leiterbahnen C1, C2 und Anschlusselemente F1....F7 abdeckt und hier aus einem Einscheiben-Sicherheitsglas besteht, weisen eine Lichtdurchlässigkeit auf, die nur 30 % der Lichtdurchlässigkeit beträgt, die das Glas im Überdeckungsbereich mit den Solarzellen Z1....Z9 besitzt. Diese Bereiche, die als rechteckige Streifen (grau unterlegt) im Ausführungsbeispiel dargestellt sind, sind mit A1, A2 gekennzeichnet und verlaufen vom korrespondierenden Rahmenabschnitt L3, L4 bis kurz vor die nächst gelegenen Zellen (Z9, Z1), wobei sie die elektrischen Anschlusselemente F1....F7 ebenso überdecken wie Endabschnitte der Leiterbahnen C1, C2 im Verbindungsbereich zu den Anschlusselementen F1....F7.

Auf diese Weise werden einerseits Unregelmäßigkeiten in der Ausrichtung, Verlegung und Orientierung der Leiterbahnen C1, C2 und elektrischen Anschlusselemente F1....F7 quasi optisch kaschiert. Gleichzeitig erhält der Photovoltaik-Modul insgesamt ein deutlich verbessertes optisches Erscheinungsbild.

Darüber hinaus ermöglichen diese Bereiche geringerer Lichtdurchlässigkeit, die hier durch Siebdruck-Technik ausgebildet sind, die Anordnung eines elektronischen Bauteils E zwischen dem Abschnitt A1 reduzierter Lichtdurchlässigkeit und der Ebene der Siliziumzellen Z1....Z9, wobei dieses elektronische Bauteil E zur Identifizierung des Photovoltaik-Moduls beziehungsweise dessen Eigenschaften dient und als so genannter RFID-Chip ausgebildet ist.

Die Anordnung des elektronischen Bauteils E ist im dargestellten Ausführungsbeispiel zwischen dem vierten und fünften string (zwischen S4 und S5) und etwa in einer Linie mit den benachbarten elektrischen Anschlusselementen F6, F7. Es ist wichtig, dass das elektronische Bauteil E keinen elektrischen Kontakt zu elektrisch leitenden Abschnitten des Photovoltaik-Moduls ermöglicht und entsprechend außerhalb der Fläche angeordnet ist, die von den Solarzellen belegt wird.

## Patentansprüche

1. Photovoltaik-Modul mit mehreren Photovoltaik-Zellen (Z1...Z9), die nebeneinander entlang einer Ebene angeordnet und von einer lichttransparenten Schicht abgedeckt sind, wobei Leiterbahnen (C1, C2) benachbarte Photovoltaik-Zellen (Z1, Z2; Z2, Z3;...Z8, Z9) elektrisch miteinander verbinden und Gruppen (S1...S6) von Photovoltaik-Zellen (Z1...Z9) über elektrische Anschlusselemente (F1...F7) verbunden sind, **dadurch gekennzeichnet, dass** die lichttransparente Schicht im Überdeckungsbereich der elektrischen Anschlusselemente (F1...F7) zumindest einen Bereich (A1, A2) aufweist, der eine um mindestens die Hälfte reduzierte Lichtdurchlässigkeit gegenüber den die Photovoltaik-Zellen (Z1...Z9) überdeckenden Bereichen hat.

2. Photovoltaik-Modul nach Anspruch 1, bei dem die lichttransparente Schicht in den die Photovoltaik-Zellen überdeckenden Bereichen eine Lichtdurchlässigkeit von mindestens 80% aufweist.

3. Photovoltaik-Modul nach Anspruch 1, bei dem die lichttransparente Schicht in den die Photovoltaik-Zellen überdeckenden Bereichen eine Lichtdurchlässigkeit von mindestens 90% aufweist.

4. Photovoltaik-Modul nach Anspruch 1, bei dem die lichttransparente Schicht aus Glas besteht.

5. Photovoltaik-Modul nach Anspruch 1, bei dem der Bereich (A1, A2) der lichttransparenten Schicht mit reduzierter Lichtdurchlässigkeit eine Lichtdurchlässigkeit von weniger als 40% aufweist.

6. Photovoltaik-Modul nach Anspruch 1, bei dem der Bereich (A1, A2) der lichttransparenten Schicht mit reduzierter Lichtdurchlässigkeit eine Lichtdurchlässigkeit von weniger als 30% aufweist.

7. Photovoltaik-Modul nach Anspruch 1, bei dem der Bereich (A1, A2) der lichttransparenten Schicht mit reduzierter Lichtdurchlässigkeit eine Siebdruck-Beschichtung aufweist.

8. Photovoltaik-Modul nach Anspruch 1, bei dem der Bereich (A1, A2) der lichttransparenten Schicht mit reduzierter Lichtdurchlässigkeit eine Färbung aufweist.

9. Photovoltaik-Modul nach Anspruch 1, bei dem der Bereich (A1, A2) der lichttransparenten Schicht mit reduzierter Lichtdurchlässigkeit eine geätzte Oberfläche aufweist.

10. Photovoltaik-Modul nach Anspruch 1, bei dem der Bereich (A1, A2) der lichttransparenten Schicht mit reduzierter Lichtdurchlässigkeit streifenförmig ist.

11. Photovoltaik-Modul nach Anspruch 10, bei dem der Bereich (A1, A2) der lichttransparenten Schicht mit reduzierter Lichtdurchlässigkeit im Randbereich (L3, L4) des Photovoltaik-Moduls und parallel zu diesem Randbereich (L3, L4) verläuft.

12. Photovoltaik-Modul nach Anspruch 11, mit einem zwischen der lichttransparenten Schicht und der Ebene der Photovoltaik-Zellen (Z1...Z9) angeordneten Sensor (E) zur Identifizierung des Photovoltaik-Moduls, wobei der Sensor (E) so positioniert ist, dass er keine der Photovoltaik-Zellen (Z1...Z9) und keine der Leiterbahnen (C1, C2) oder elektrischen Anschlusselemente (F1...F7) überdeckt.

13. Photovoltaik-Modul nach Anspruch 11, mit einem in der Ebene der Photovoltaik-Zellen (Z1...Z9) angeordneten Sensor (E) zur Identifizierung des Photovoltaik-Moduls, wobei der Sensor (E) so positioniert ist, dass er keine der Photovoltaik-Zellen (Z1...Z9) und keine der Leiterbahnen (C1, C2) oder elektrischen Anschlusselemente (F1...F7) überdeckt.

14. Photovoltaik-Modul nach Anspruch 12 oder 13, wobei der Sensor (E) zumindest teilweise von dem Bereich (A1, A2) der lichttransparenten Schicht mit reduzierter Lichtdurchlässigkeit überdeckt wird.

15. Photovoltaik-Modul nach Anspruch 12 oder 13, wobei der Sensor (E) von dem Bereich (A1, A2) der lichttransparenten Schicht mit reduzierter Lichtdurchlässigkeit überdeckt wird und im Überdeckungsfeld (A1, A2) mindestens eine optische Markierung zur Identifizierung der Position des Sensors vorgesehen ist.
